# FASCICULE DE BREVET EUROPEEN

(11) **EP 2 162 915 B1**
(45) Date de publication et mention de la délivrance du brevet: **09.09.2020**
(21) Numéro de dépôt: 08760580.4
(22) Date de dépôt: 05.06.2008
(51) Int. Cl.: H01L 23/538, H01L 25/10, H01L 21/56, H01L 21/60

(54) **PROCÉDÉ DE RÉALISATION DE VIA DANS UN SUBSTRAT RECONSTITUÉ ET DISPOSITIF CORRESPONDANT**
VERFAHREN ZUR HERSTELLUNG EINER DURCHGANGSVERBINDUNG IN EINEM REKONSTITUIERTEN SUBSTRAT UND ENTSPRECHENDE VORRICHTUNG
METHOD OF PRODUCING A VIA IN A RECONSTITUTED SUBSTRATE AND CORRESPONDING DEVICE

(30) Priorité: 07.06.2007 FR 0755577
(43) Date de publication de la demande: 17.03.2010
(73) Titulaire: Commissariat à l'Énergie Atomique et aux Énergies Alternatives, 75015 Paris (FR)
(72) Inventeur: BALERAS, François, F-38450 Saint Georges de Commiers (FR); SOURIAU, Jean-Charles, F-38120 Saint-Egreve (FR); HENRY, David, 38240 MEYLAN (FR)
(74) Mandataire: Ilgart, Jean-Christophe
(86) Numéro de dépôt international: PCT/EP2008/057004
(87) Numéro de publication internationale: WO 2008/155233

(56) Documents cités:
- WO-A-03/081669
- WO-A-2005/041295
- DE-B3- 10 345 391
- US-A- 5 471 088
- US-A- 5 663 596
- US-A1- 2002 027 019
- US-A1- 2002 171 133
- US-A1- 2003 112 610
- US-A1- 2005 184 377
- J. ZOU ET AL.: "Plastic deformation magnetic assembly (PDMA) of out-of-plane microstructures: Technology and application" JOURNAL OF MICROELECTROMECHANICAL SYSTEMS, vol. 10, no. 2, juin 2001 (2001-06), pages 302-309, XP002470004 cité dans la demande

## Description

### DOMAINE TECHNIQUE ET ART ANTÉRIEUR

L'invention concerne le domaine de l'intégration de composants.

Elle propose de réaliser des substrats de composants intégrés, substrats qui contiennent notamment des interconnexions verticales et qui sont adaptés à la réalisation d'empilements de composants.

L'augmentation de la densité d'intégration des composants, la recherche de l'amélioration des performances et la diminution des coûts, mènent les fournisseurs de systèmes électroniques à développer des dispositifs de plus en plus compacts.

On connaît de nouvelles techniques d'intégration qui permettent d'augmenter la compacité des puces ou systèmes tout en en réduisant le coût et en en conservant la fiabilité.

Ainsi, le document EP 1 596 433 décrit le concept de « néo-wafers », qui consiste à fabriquer un wafer à partir de puces nues (puces électroniques découpées) testées et déterminées. On applique sur ces substrats des étapes technologiques élémentaires pour réaliser une redistribution des entrées/sorties des puces afin de permettre le montage final sur un PCB (circuit imprimé).

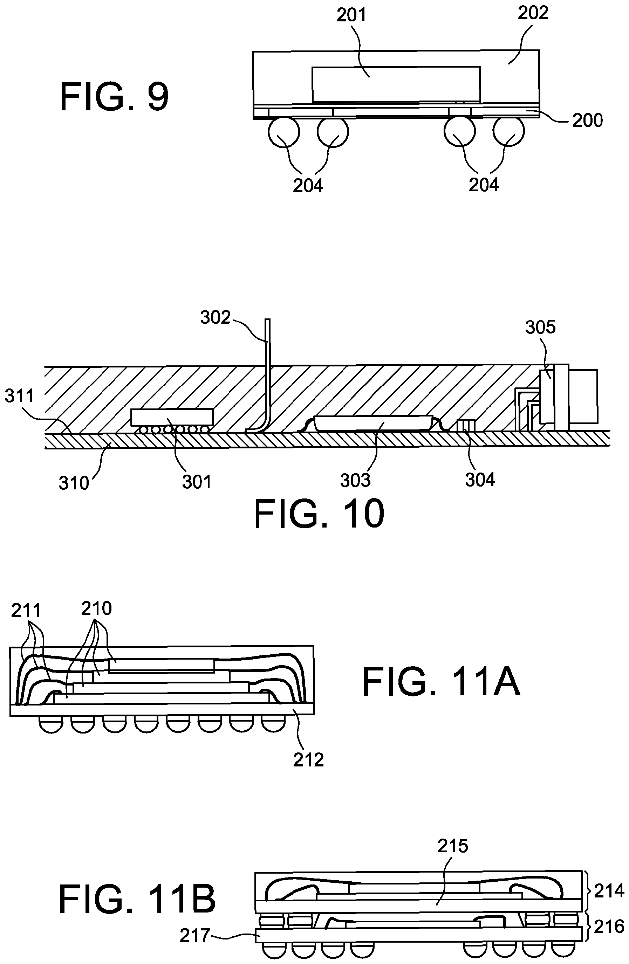

La figure 9 montre un autre type de technique connue d'encapsulation d'un composant 201 découpé. Sur cette figure, on identifie la redistribution d'entrées/sorties 200 à la base du composant 201, lui-même enrobé dans un matériau d'enrobage 202, et les billes 204 qui serviront au montage sur un circuit imprimé, non représenté sur la figure. Cette technique permet la redistribution des entrées/sorties des puces. Ce procédé de reroutage est directement appliqué sur toutes les puces fonctionnelles déjà enrobées.

Les deux techniques mentionnées ci-dessus permettent en outre, en réalisant l'interconnexion entres des puces, de réaliser un système à l'échelle d'un substrat (wafer), qui peut comporter des puces de technologies ou de fonderies différentes.

Dans les deux cas, on peut obtenir une bonne compacité, avec un rendement de fabrication de l'ordre de 100 %.

Mais la densité d'intégration doit être encore améliorée, en utilisant la troisième dimension : l'empilement des composants réduit encore les longueurs de connexions et favorise les montées en fréquence de fonctionnement.

Pour cela, on cherche à développer les connexions verticales à l'intérieur de substrats reconstitués, ce que les techniques mentionnées ci-dessus ne permettent pas de réaliser.

Le document US 2006/0057773 décrit un procédé pour réaliser l'empilement d'au moins deux puces avec une connexion électrique entre elles. Des capillaires sont formés autour de chaque puce, puis sont métallisés par pulvérisation d'une couche métallique, photolithographie et recharge électrolytique.

Lors de l'empilement de puces, les capillaires sont remplis avec de la soudure en phase liquide.

Cette technologie présente divers inconvénients, notamment celui d'être développée après la pose des puces, mais aussi celui d'être onéreuse : elle met en oeuvre plusieurs étapes (dont 2 étapes de lithographie), et une gravure plus ou moins profonde dans le matériau ; se posent également des difficultés de remplissage, ou de bouchage des vias par des particules créées lors d'étapes de gravure ou de polissage. Enfin se pose le problème de testabilité en fin de procédé : il faut en effet éliminer le support et réaliser un polissage avant de pouvoir tester la continuité du via.

Le document FR 2 864 342 décrit un procédé d'interconnexion de composants électroniques tels que des boîtiers ou des puces, sans apport de brasure, permettant ainsi des applications à hautes températures. Il décrit aussi un dispositif électronique obtenu par un tel procédé. Un dépôt d'une couche de résine assure le maintien mécanique des composants. Un surfaçage de l'ensemble permet de faire apparaître des zones conductrices des sorties externes des boîtiers, en vue de leur connexion.

La figure 10 reproduit un mode de réalisation de ce document : un simple fil de connexion 302, de section d'épaisseur 100 µm à 200 µm permet de connecter un niveau inférieur à un niveau supérieur d'un circuit réalisé sur plusieurs niveaux. Sur cette figure, les références 301, 303-305 désignent divers composants, par exemple un boîtier 303, un condensateur 304, et un connecteur 305. Ces divers composants sont reportés, par leurs sorties externes, sur la face supérieure 311 d'un support 310 destiné à être éliminé par la suite.

Mais cette technologie pose elle aussi certaines difficultés :
- il faut maintenir un fil vertical 302 sur toute l'épaisseur de substrat,
- il y a une limitation en terme de pas, c'est-à-dire qu'il faut disposer d'un outillage spécifique pour la dépose du fil 302,
- une distance minimum entre les composants et les fils doit être respectée, du fait de l'outillage spécifique de pose de composants ou de fils.

Posent également problème la précision de positionnement des interconnexions, le coût de mise en œuvre (qui dépend du nombre de connexions), la testabilité en fin de procédé, le repérage des interconnexions sur le substrat, et le désalignement des fils les uns avec les autres.

D'autres techniques d'amélioration de la compacité sont décrites dans l'art antérieur.

Par exemple, dans le document « A study on package stacking process for package on package (PoP) », Yoshida A. et al., 2006, ECTC IEEE conference, sont décrites deux techniques, dites "CSP" et "PoP":
- la technique CSP, illustrée en figure 11A, consiste à empiler des puces 210, à faire la connexion entre les différents étages de l'empilement, puis à encapsuler l'ensemble. Pour un système comportant plus de deux étages, le nombre d'opérations est relativement élevé, puisqu'on procède alors à un montage puce par puce. En outre les interconnexions 211 passent systématiquement par le support 212 du bas de l'empilement pour éviter les croisements des fils, ce qui implique un allongement et un placement délicat de ces interconnexions,
- la technique PoP, illustrée en figure 11B, permet de monter uniquement des composants 214, 216 testés et déterminés. Mais ce montage se fait au détriment de la compacité et, en outre, on retrouve le problème - mentionné ci-dessus - des interconnexions ramenées vers le support 215, 217 du bas de chaque étage pour éviter les croisements des fils, ce qui implique, là encore, un rallongement et un placement délicat des interconnexions.

Le document US 2002/171133 A1 décrit par ailleurs des éléments de contact verticaux qui sont d'abord formés horizontalement puis relevés par l'effet de contraintes mécaniques internes ainsi que des procédés de réalisation de tels éléments de contact verticaux.

Il se pose donc le problème de trouver de nouveaux procédés pour réaliser des substrats reconstitués de composants ou de puces, en particulier du type compatible avec un empilement ou une intégration 3D.

### EXPOSÉ DE L'INVENTION

La présente invention concerne d'abord un procédé de réalisation d'un dispositif électronique de connexion, selon la revendication 1

Selon l'invention, on réalise un ou des premiers éléments de contact, qui peuvent faire partie d'un ensemble de pistes (reroutage horizontal) en surface d'un support de fabrication. Un ou des vias (deuxièmes éléments de contact) permettent de former une connexion suivant une direction sensiblement perpendiculaire au plan du substrat. Au moins une partie du ou des deuxièmes éléments de contact sont réalisés simultanément ou en même temps, ou lors d'une même étape, que le ou les premiers éléments de contact, mais avant le positionnement des composants sur ce ou ces premiers éléments de contact et avant enrobage. Cette technique limite les étapes de procédé et donc le coût de fabrication du dispositif, et assure un positionnement précis des vias. Les composants peuvent ensuite être positionnés et montés sur le ou les premiers éléments de contact; enfin, un enrobage global du substrat peut être réalisé.

L'invention permet de réaliser un reroutage vertical des connexions de composants, sans former des vias dans un quelconque substrat préexistant, et notamment pas dans les composants ou à travers les composants eux-mêmes. En outre, elle évite de ramener les connexions des divers composants à partir de leurs surfaces actives vers un plan d'un support situé sous ces composants.

Avant même le positionnement et le montage des composants ou des puces, les performances électriques du ou des premiers et/ou deuxièmes éléments de contact peuvent être contrôlées. Les zones de connexions défectueuses peuvent donc être identifiées et localisées, et éventuellement éliminées, avant montage des composants. On réduit ainsi la perte de puces fonctionnelles, puisque le risque est éliminé que des puces soient montées sur des connexions défectueuses.

Il est également possible de tester le fonctionnement des composants, après leur montage sur le ou les premiers éléments de contact (ou sur le reroutage horizontal), et avant l'étape suivante d'enrobage. On peut ainsi éliminer et remplacer les composants défectueux, ce qui permet de maintenir des rendements de fabrication élevés.

Par conséquent, une ou des étape(s) de test des éléments de contact et/ou des composants peut/peuvent avantageusement être réalisée(s) avant l'étape b) et/ou avant l'étape c).

L'invention concerne également un dispositif électronique de connexion, selon la revendication 10.

Selon une réalisation, au moins une partie du ou des premiers éléments de contact et au moins une partie des deuxièmes éléments de contact comportent une même couche continue de matériau conducteur.

Dans un procédé selon l'invention,
le ou les deuxièmes éléments de contact peuvent comporter des pistes ou poutres ou bras métalliques formés horizontalement, ou parallèlement à la surface du substrat, ou un empilement d'au moins deux couches, formant bilame, puis redressés, suivant ladite direction perpendiculaire à cette surface, par exemple par effet mécanique ou sous l'action d'une force appliquée telle qu'une force d'origine magnétique.

Les pistes ou poutres ou bras métalliques sont libérées, du substrat ou à partir d'un plan parallèle au substrat et sont au moins partiellement redressées suivant une direction sensiblement perpendiculaire au substrat support. Il peut en résulter, après redressement, une courbure de ces pistes ou poutres ou bras.

Selon un mode de réalisation ces pistes ou poutres ou bras métalliques, par exemple un bilame, sont formés sur une couche sacrificielle qui est ensuite éliminée. Il y a redressement mécanique au moins partiel des pistes ou poutres ou bras, selon une direction perpendiculaire au substrat, lors de l'élimination de la couche sacrificielle.

Selon un autre mode de réalisation ces pistes ou poutres ou bras métalliques sont au moins en partie magnétiques, et sont redressés au moins partiellement sous l'action d'un champ magnétique après l'élimination de la couche sacrificielle.

Dans les deux cas on amène le ou les deuxièmes éléments de contact à être redressés, depuis une position parallèle au subtrat, suivant une direction verticale ou perpendiculaire au substrat. Mais, encore une fois, ces éléments peuvent présenter une certaine courbure dans leur partie redressée.

Un procédé selon l'invention peut comporter la formation d'un ou plusieurs circuits (circuits de reroutage horizontal) dans le plan du substrat support, dont fait ou font partie le ou les premiers éléments de contact ; un dispositif selon l'invention peut comporter un ou plusieurs de ces circuits.

Le substrat support peut être éliminé, auquel cas la face qu'il laisse libre peut être recouverte d'une couche de passivation, sur laquelle un ensemble de connexions peut être élaboré. Le substrat peut cependant être maintenu si, par exemple, il s'agit d'un support actif ou d'un substrat transparent dans une certaine gamme de longueurs d'onde (l'un des composants comportant une fonction optique).

Après l'étape a) et avant l'étape c), un cadre peut être positionné, afin de délimiter des zones de remplissage, comportant plusieurs compartiments dans chacun desquels est positionné au moins un composant.

L'invention concerne également un procédé de réalisation d'un dispositif électronique compact, comportant la réalisation d'au moins un premier dispositif tel que ci-dessus, et un empilement de ce dispositif avec un deuxième dispositif, éventuellement lui aussi obtenu par un procédé selon l'invention.

L'invention concerne également un dispositif électronique compact, comportant au moins un premier dispositif selon l'invention, et un empilement de ce dispositif avec un deuxième dispositif, éventuellement lui aussi selon l'invention.

### BRÈVE DESCRIPTION DES DESSINS

- Les figures 1A-1J représentent un premier mode de réalisation d'un procédé non couvert, à lui seul, par les revendications.
- Les figures 2A-2I représentent un deuxième mode de réalisation d'un procédé selon l'invention.
- La figure 3 présente des exemples de picots en polymères pouvant être utilisés dans le cadre d'un mode de réalisation non couvert, à lui seul, par les revendications.
- La figure 4 représente un dispositif non couvert, à lui seul, par les revendications.
- Les 5A-5C représentent des dispositifs obtenus par un procédé selon l'invention.
- Les figures 6A-6C représentent schématiquement divers exemples de répartition d'un composant et de vias à proximité de ce composant.
- Les figures 7 et 8 représentent des assemblages de dispositifs obtenus par un procédé selon l'invention.
- Les figures 9, 10, 11A et 11B représentent des structures connues de l'art antérieur.

### EXPOSÉ DÉTAILLÉ DE MODES DE RÉALISATION PARTICULIERS

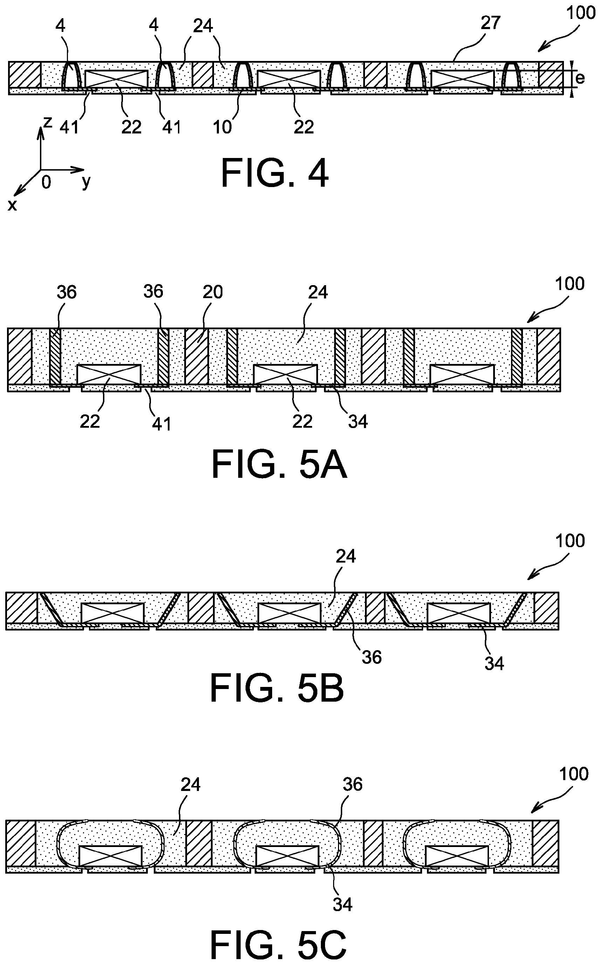

Des exemples de composants obtenus par un procédé selon l'invention seront décrits ci-dessous, en particulier en liaison avec les figures 5A-8; mais préalablement, vont être détaillés des exemples de procédés de réalisation de ces composants.

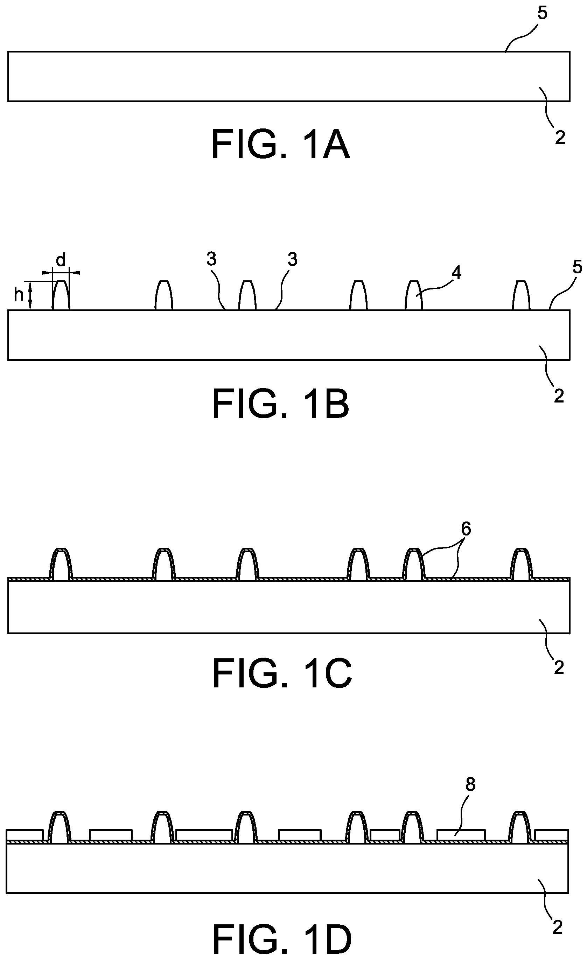

Un exemple d'un procédé de réalisation, non couvert, à lui seul, par les revendications, est donné en liaison avec les figures 1A-1J.

Dans cet exemple un préroutage « vertical », c'est-à-dire suivant une direction perpendiculaire à un substrat 2, comporte des picots 4, de forme sensiblement cylindrique ou tronconique. Ces picots peuvent être isolants ou conducteurs, et sont munis d'un revêtement métallisé 11.

Les dimensions des picots peuvent varier dans la gamme suivante : hauteur comprise entre 100 µm et 1 mm, pour un diamètre compris entre 20 µm et 100 µm ; par exemple les picots ont une hauteur de 100 µm pour un diamètre de 20 µm, ou une hauteur de 1 mm pour un diamètre de 100 µm. On peut aussi avoir des dimensions plus petites si les puces sont amincies. Par exemple, si on a des puces de 50 µm d'épaisseur, on peut réaliser des picots métalliques (par croissance électrolytique de cuivre à travers une résine photosensible) de 60 µm à 80 µm de diamètre équivalent.

Dans une première étape (figures 1A et 1B) on réalise ces picots 4 sur un même côté d'un support 2, par exemple en verre ou en quartz. D'autres types de substrats sont possibles, en particulier des substrats actifs.

Ces picots 4 ont un rapport de forme (et notamment un rapport h/d, entre leur hauteur et leur dimension transverse moyenne ou leur diamètre moyen), tels qu'ils pourront assurer la fonction de connexions ou de vias conducteurs, tout en occupant une surface minimale sur le plan du substrat 2 sur lequel ils sont positionnés ou formés et tout en assurant la rigidité voulue dans le plan de la figure et/ou perpendiculairement à ce plan.

Ces picots peuvent être en matériau isolant ou conducteur, par exemple en matériau plastique, ou en un polymère conducteur, ou en un polymère chargé, par exemple de particules conductrices, ou en tout autre matériau conducteur. Ils seront recouverts, complètement ou au moins en partie, d'une couche conductrice.

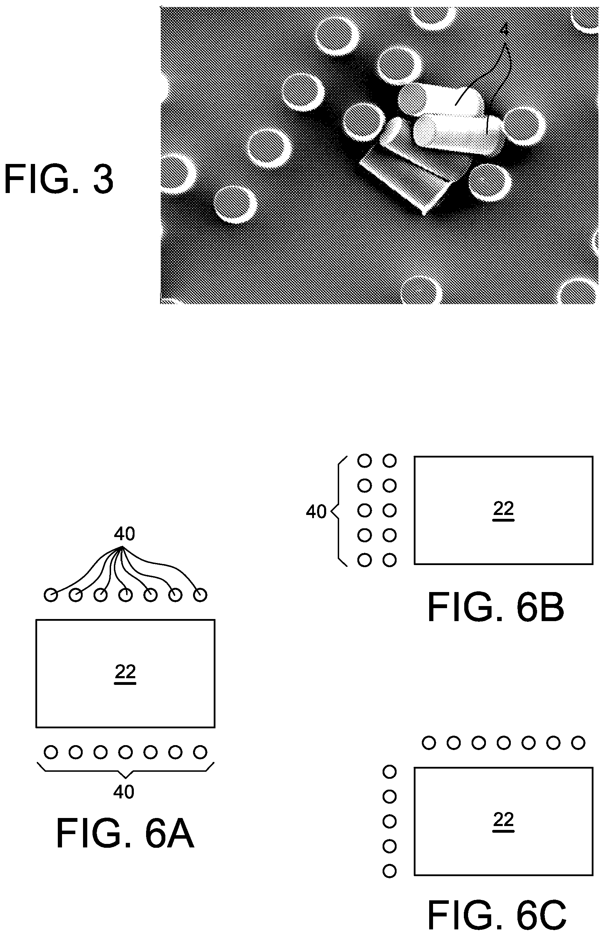

La figure 3 représente un cliché de tels picots 4 en polymère. Ces picots peuvent être obtenus par photolithographie d'une résine (Su8 par exemple) sur le substrat support 2.

Plus généralement, différentes méthodes peuvent être mises en oeuvre pour la fabrication de ces picots: moulage, photolithographie, procédé de type « métal Injection molding », report de billes conductrices....

Puis (figure 1C) on dépose (par exemple par pulvérisation) un fond continu 6 d'une couche conductrice (en vue d'une croissance électrolytique) telle que du TiCu. Cette couche recouvre l'ensemble du substrat, tant les picots 4 que les zones 3 (en surface 5 du support 2) situées entre les picots.

Par une technique telle que la photolithographie, on réalise (figure 1D) des motifs 8 qui vont permettre de délimiter, lors de l'étape suivante, la formation d'un reroutage ou d'un ensemble de pistes conductrices sur la surface du substrat 2. Ces motifs peuvent être en résine, déposée par exemple en spray.

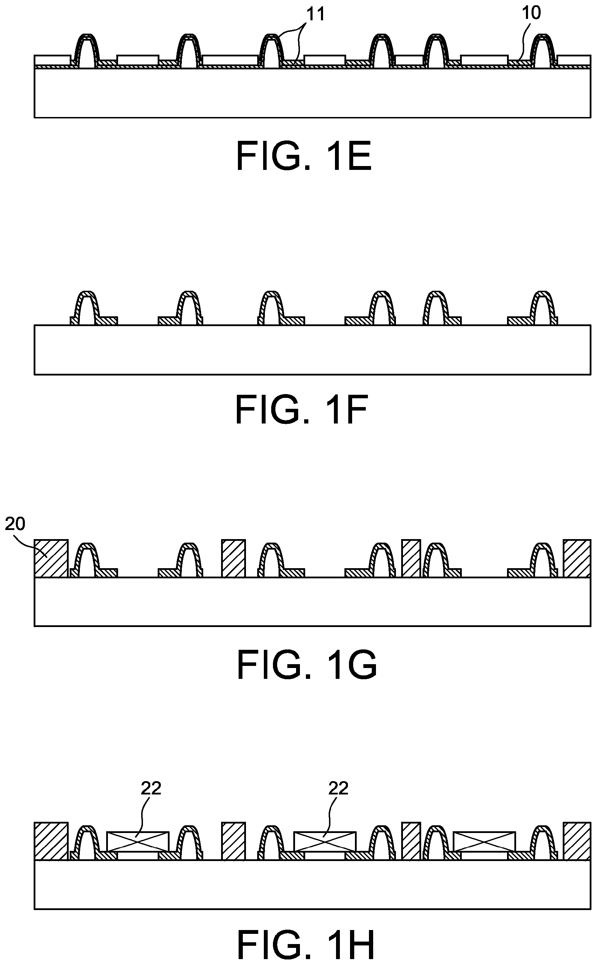

Lors de l'étape suivante (figure 1E) est donc formé ce reroutage « horizontal » ou en surface 5 du substrat support 2 ou de la couche 6. Font notamment partie de ce reroutage horizontal les plots conducteurs 10, par exemple en cuivre, qui permettront de positionner les composants lors d'une étape ultérieure. Sur la figure 1E apparaissent seulement les plots 10, mais le reroutage horizontal peut comporter en fait un système complexe de pistes et de connexions sur le substrat support, y compris dans le plan perpendiculaire à celui de la figure. La technique utilisée pour la formation de ce reroutage est par exemple une technique de croissance électrolytique.

Au cours d'une même opération, par exemple de dépôt, on peut réaliser, éventuellement simultanément, un même revêtement conducteur 11 sur au moins une partie des premiers éléments de contact 10, ou même formant ces premiers éléments de contact 10, et au moins une partie des deuxièmes éléments de contact (picots). Ces premiers et deuxièmes éléments de contact comportent ce revêtement conducteur.

Ainsi est réalisé à la fois, ou simultanément ou au cours d'une même étape, ou en tout cas avant montage des composants ou des puces, le reroutage « horizontal », dont les plots 10 (premiers éléments de contact), les picots, et le contact électrique entre ce reroutage horizontal ou ces plots et ces picots (deuxièmes éléments de contact). Les plots conducteurs 10, formés en surface de la couche 6 ou du substrat 2, sont adaptés à recevoir, au cours d'une étape ultérieure, des composants 22.

Selon une variante, le ou les picots peuvent être réalisés directement sur les premiers éléments de contact ou des pistes métalliques d'un reroutage horizontal. Une métallisation permet de les relier en une étape au ou aux premiers éléments de contact, pour obtenir le reroutage tridimensionnel. On peut enchaîner ensuite par les étapes suivantes : pose des composants et enrobage.

Par exemple, on peut réaliser les picots après la formation des pistes ou du reroutage horizontal et notamment des plots 10. Par exemple encore, la résine Su8 (conductrice ou non) étant une résine photosensible, on réalise les picots sur les pistes. Si le matériau n'est pas conducteur, on rajoute des étapes pour métalliser les picots. On peut former, là encore, par une même opération, un même revêtement conducteur 11 sur au moins une partie des premiers éléments de contact 10 et au moins une partie des deuxièmes éléments de contact (picots). Eventuellement, et comme représenté en figure 1E, le même revêtement conducteur 11 recouvre entièrement les premiers éléments de contact 10 et les deuxièmes éléments de contact 4.

Par le procédé exposé ci-dessus au moins une partie des premiers éléments 10 de contact et au moins une partie des deuxièmes éléments 4 de contact comportent une même couche continue 11 de matériau conducteur.

La résine 8 est ensuite éliminée (figure 1F) et le fond continu 6 est gravé, laissant subsister le reroutage horizontal, ou plan, et en particulier les plots conducteurs 10, ainsi que les picots 4 avec lesquels ces plots sont en contact électrique. Ces picots constituent les vias, qui permettent de rediriger les contacts électriques à partir des plots conducteurs 10 suivant au moins une direction z perpendiculaire au plan xOy défini par la surface 5 du support 2. A ce stade, des tests des pistes de reroutage et des picots peuvent être réalisés. Avant même le positionnement des composants, on peut donc identifier des pistes ou des zones de contact déficientes, éventuellement les réparer, et sinon éviter de les utiliser ensuite pour des composants.

On peut ensuite coller ou disposer un cadre ou un treillis 20 pour délimiter des zones de remplissage. Par exemple on peut coller un cadre et remplir la cavité globale ou mettre un treillis et remplir les différentes cavités. Le positionnement du cadre ou du treillis peut avoir lieu après montage des puces.

Des composants ou puces 22 sont montés (par collage isolant, ou conducteur, ou par thermo-compression...) en contact avec les plots 10. Il y a alors contact, d'une part, entre ces composants et les plots 10, et, d'autre part, entre ces derniers et les picots 4. Selon le mode de montage des composants, on peut éventuellement ajouter une étape de métallisation des puces 22 pour la reprise des contacts sur les plots 10.

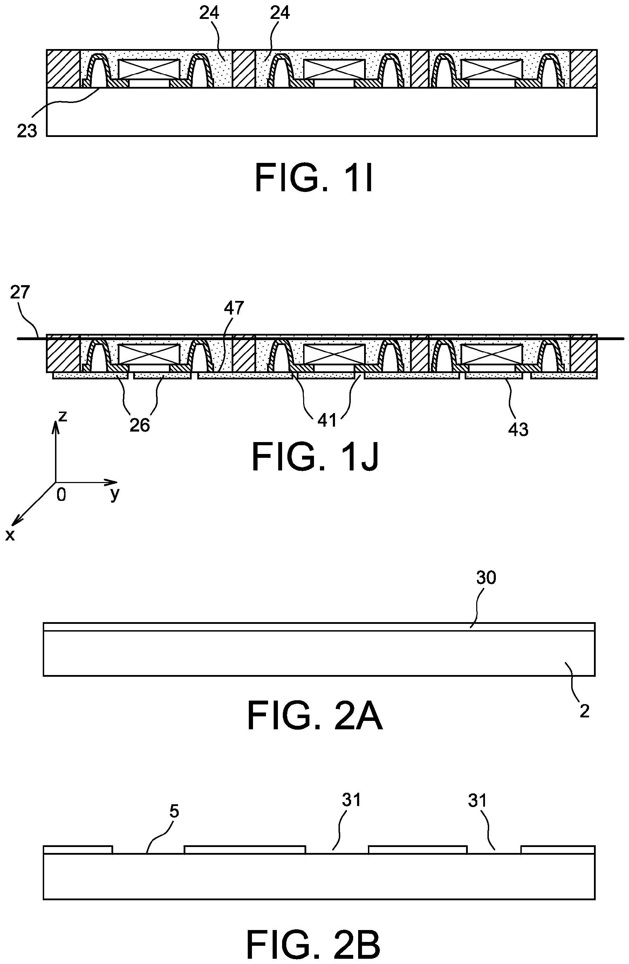

On peut ensuite recouvrir l'ensemble, par exemple en remplissant les cavités ou les zones formées par le cadre 20, avec un produit d'enrobage 24, tel qu'une résine de type epoxy (figure 1I).

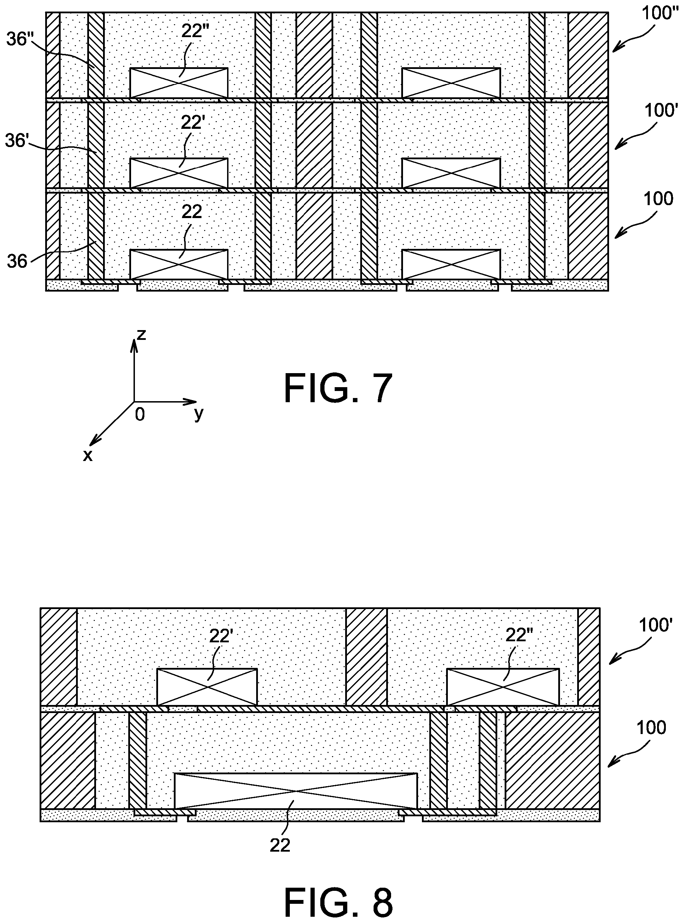

Un amincissement ou un surfaçage de l'ensemble permet de ramener la surface supérieure d'enrobage au niveau d'un plan 27 qui fait apparaître des zones conductrices correspondant à l'extrémité supérieure des picots métallisés ou métalliques 4 (figure 1J). On a ainsi formé une surface de connexion, dans laquelle affleurent les zones conductrices formées par les extrémités supérieures métallisées ou métalliques des picots. Cette surface de connexion permettra, ultérieurement, d'accueillir par exemple un étage supplémentaire de composants en vue de la réalisation d'un empilement, comme illustré sur les figures 7 et 8.

Les picots peuvent servir de contrôle pour la profondeur d'amincissement. Par exemple, on observe leur apparition à certaines altitudes dans le substrat ou on réalise un ou des profils de picots qui permettent, grâce à une mesure dimensionnelle, de connaître la profondeur de l'amincissement. Plus généralement, un dispositif réalisé selon ce mode de réalisation peut comporter des mires de contrôle pour la profondeur d'amincissement du matériau d'enrobage ; on peut ainsi observer l'apparition de mires à certaines altitudes dans l'enrobage, ou encore réaliser des profils de mires qui permettent, grâce à une mesure dimensionnelle, de connaître la profondeur de l'amincissement de l'enrobage.

Enfin, il peut être procédé au décollement du support 2 et à une passivation de la surface 23, laissée libre par l'élimination du substrat support, et définie par la base des picots 4, des plots 10, et éventuellement par la base du reroutage horizontal et/ou de la partie inférieure du matériau d'enrobage située sous les composants 22. On peut notamment réaliser sur cette surface une couche de matériau diélectrique photosensible 26 (figure 1J). Des ouvertures 41 peuvent y être gravée, à partir desquelles il sera possible d'établir d'autres connexions, par exemple d'un premier composant 22 à un deuxième situé dans le même plan que le premier, ou entre deux étages de dispositifs empilés, comme illustré en figure 7. Par exemple, on réalise ces connexions externes, ou ce reroutage arrière, par une étape de métallisation sur la face 43 de la couche 26 opposée à la face 47 de cette même couche tournée vers les composants 22. Les vias formés par les picots 4 peuvent servir de motifs d'alignement pour des étapes de photolithographie sur cette face 43.

Un exemple de fabrication selon l'invention est donné en relation avec les figures 2A-2I.

Dans cet exemple, les éléments de contact verticaux sont d'abord formés horizontalement, puis relevés par l'effet de contraintes, par exemple des contraintes mécaniques internes ou sous l'effet d'un champ magnétique externe.

Dans une première étape (figure 2A) on dépose une couche sacrificielle 30 sur un support 2 par exemple en verre ou en quartz. Cette couche 30 est par exemple en oxyde de silicium SiO2 ou en résine photosensible ou en polymère photosensible, ou en polyimide.

Par une technique telle que la photolithographie, on délimite des ouvertures 31 dans cette couche sacrificielle (figure 2B).

On fabrique ensuite un bilame (poutre constituée au minimum de deux matériaux dont le coefficient de dilations thermiques sont différents l'un de l'autre ; on peut aussi obtenir le même effet si les matériaux sont déposés à des températures différentes) par dépôt de plusieurs matériaux 34, 36 (par exemple polysilicium/ CrAu). Une première partie 34 est formée sur la surface 5 du substrat 2, dans les zones de bord (mais à l'intérieur) des ouvertures 31. Une deuxième partie 36 est formée partiellement en contact avec la première partie 34 et partiellement sur la couche sacrificielle 30.

Par exemple, les couches des matériaux 36 et 34 sont déposés, simultanément ou au cours d'une même étape, respectivement sur la couche sacrificielle 30 et sur la surface 5; puis on réalise la poutre par une opération de lithographie et par des gravures des couches 36 et 34 (ces étapes ne sont pas illustrées sur les figures 2A - 2I). La poutre comporte donc une partie sur la couche sacrificielle 30 et une partie fixée sur la surface 5 du support.

En termes de dimensions, on peut avoir par exemple une couche 30 en SiO2, d'épaisseur environ 2 µm, déposé par PECVD, une épaisseur de polysilicium 34 de 1,5 µm et une épaisseur 36 de CrAu de 0,5 µm.

En ce qui concerne le choix des matériaux: la poutre est par exemple constituée d'une couche 36 conductrice (Au, Al, Ti) et d'une couche 34 possédant de bonnes propriétés mécaniques (oxyde, nitrure, polysilicium...)

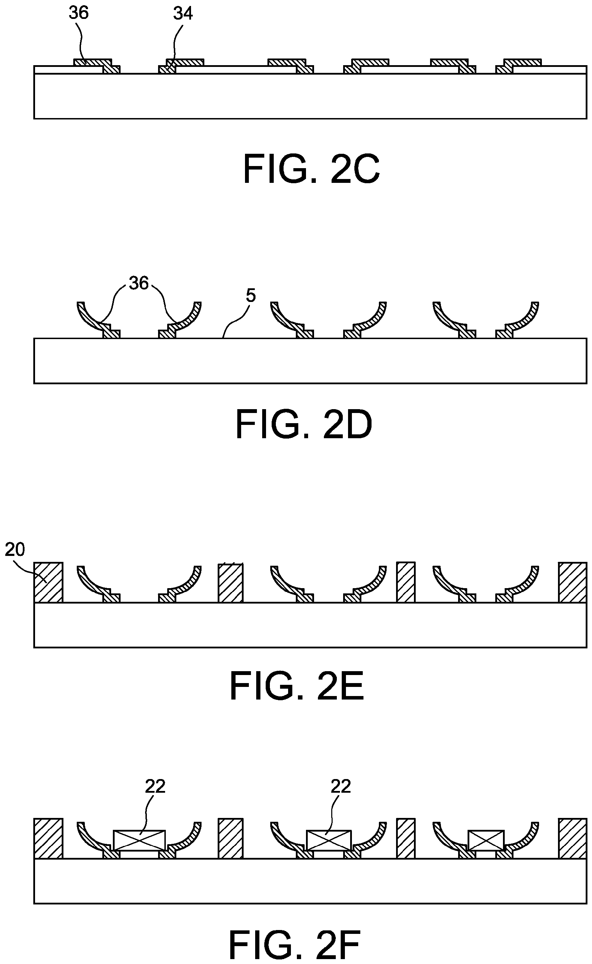

Sur les figures 2C et suivantes, seuls des plots de la première partie 34, formée sur la surface 5 du substrat 2, apparaissent. En fait il est possible de réaliser lors de cette étape un reroutage horizontal, sur la surface 5, comportant un système complexe de pistes et de connexions, dans le plan de cette surface, perpendiculairement au plan de la figure.

Cette technique permet donc de réaliser, là encore, par une même opération de dépôt, au moins une partie des premiers éléments de contact 34 et au moins une partie des deuxièmes éléments de contact 36. Les premiers éléments de contact et les deuxièmes éléments de contact comportent une même couche continue de matériau conducteur.

On élimine ensuite la couche sacrificielle 30 (figure 2D), et notamment les parties de cette couche situées sous les deuxièmes parties 36 de matériau du bilame. Il se produit alors un effet de libération ou de redressement du bilame, effet découlant des contraintes mécaniques des couches. Sont ainsi formées des pistes ayant au moins une direction perpendiculaire à la surface 5, au plan du substrat et au plan dans lequel le bilame a été initialement déposé. Un tel effet de redressement est expliqué en particulier dans l'article de Victor M.Lubecke et al., "Self-assembling MEMS variable and fixed RF inductors », paru dans IEEE transactions on microwave theory and techniques, vol 49, n°11, novembre 2001, pages 2093-2098. Dans cet article, l'effet de redressement est appliqué à la réalisation d'inducteurs RF, mais le même effet peut être obtenu pour toute poutre ou pour tout bras obtenu à partir d'un bilame formé sur une couche sacrificielle telle que la couche 30. On peut également citer l'article de G.W. Dahlmann et al., paru dans Sensors and Actuators A, 97-98, p. 215-220, 2002 en ce qui concerne cette technique.

Cet effet de redressement conduit à la structure de la figure 2D, où les électrodes 36 sont maintenues, sous l'effet des contraintes, au-dessus de la surface 5 du substrat 2, chacune ayant une forme incurvée dirigée du côté opposé au substrat 2. Du côté du substrat 2, ces électrodes sont reliées au reroutage horizontal formé sur le plan 5, et notamment aux plots 34.

Selon un autre mode de réalisation, la poutre 36 est en partie constituée d'un matériau magnétique ou comporte au moins un revêtement magnétique. Par exemple elle est en Au et est revêtue d'un matériau magnétique de type « permalloy ». Après élimination de la couche sacrificielle 30, cette poutre peut être redressée par l'application d'un champ magnétique, comme expliqué dans l'article de J.Zou et al. «Plastic Deformation assembly of out plane microstructures: technology and applications», Journal of Microelectromechanical Systems, vol. 10, n°2, Juin 2001, page 302-309.

On peut ensuite coller un cadre 20 pour délimiter des zones de remplissage (figure 2E). Le positionnement du cadre peut avoir lieu après montage des puces.

Des puces 22 peuvent ensuite être montées, par exemple par collage isolant, ou conducteur, ou par thermo-compression, en contact avec les parties 34 du reroutage horizontal formant des plots de contact en surface 5 du substrat 2 (figure 2F).

Dans le cas du montage des puces avec une colle isolante, on utilise des éléments conducteurs, sur les plots de la puce, qui transpercent la colle (par exemple des inserts métalliques ou des « bumps »). Par l'effet de la pression ou de la thermo-compression de la puce, les contacts électriques sont obtenus. On peut aussi utiliser des colles conductrices anisotropes, la conductivité électrique verticale étant obtenue lors de la thermo-compression. On peut aussi déposer une colle conductrice aux niveaux des plots de la puce.

Une reprise de contacts peut être obtenue par métallisation des puces 22. Ces puces ou composants sont donc, par ce montage, reliés d'une part aux plots, et éventuellement aux pistes de reroutage horizontal, mais aussi aux électrodes 36 formant reroutage vertical.

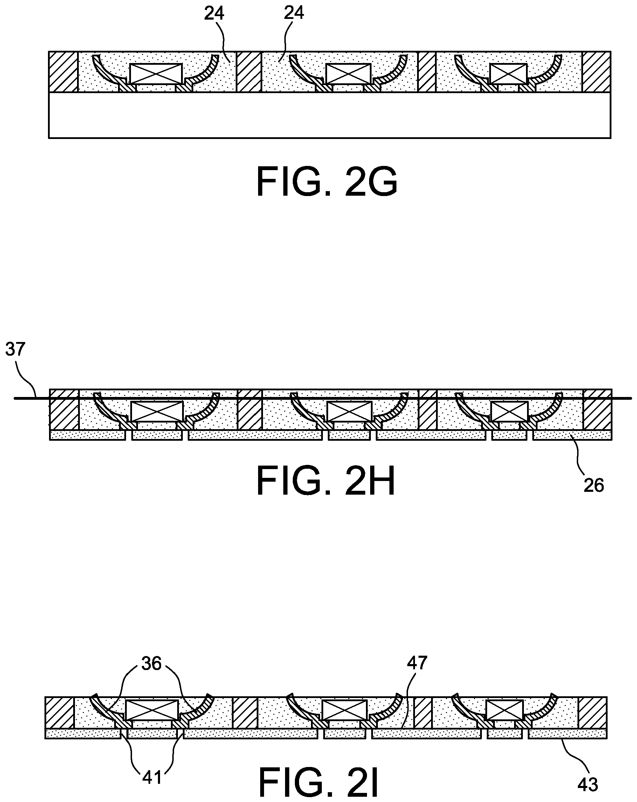

On peut ensuite recouvrir l'ensemble, par exemple en remplissant les cavités formées par les cadres 20, avec un produit d'enrobage 24, tel qu'une résine de type epoxy (figure 2G).

Un amincissement ou un surfaçage de l'ensemble permet de ramener l'enrobage au niveau d'un plan 37 qui fait apparaître des zones conductrices correspondant à l'extrémité supérieure des poutres ou des bras 36 (figure 2H). On a ainsi formé une surface de connexion, dans laquelle apparaissent, dans le matériau d'enrobage 24, des zones conductrices formées par les extrémités supérieures métallisées des bras ou des poutres 36. Cette surface de connexion permettra ultérieurement, d'accueillir, par exemple, un étage supplémentaire en vue de la réalisation d'un empilement, comme illustré sur les figures 7 et 8.

Enfin, il peut être procédé au décollement du support 2 et à une passivation de la surface 23, laissée libre par l'élimination du substrat support, définie par la base des picots 4, des plots 10, et éventuellement par la base du reroutage horizontal et/ou de la partie inférieure du matériau d'enrobage situé sous les composants 22. On peut notamment réaliser sur cette surface une couche de diélectrique photosensible 26 (figure 2I). Des ouvertures 41 peuvent y être gravées, à partir desquelles il sera possible d'établir d'autres connexions, par exemple d'un premier composant 22 à un deuxième situé dans le même plan que le premier, ou entre deux étages de dispositifs empilés, comme illustré en figure 7. Par exemple, on réalise ces connexions externes, ou ce reroutage arrière, par une étape de métallisation sur la face 43 de la couche 26 opposée à la face 47 de cette même couche tournée vers les composants 22.

Dans les procédés décrits ci-dessus, la formation, simultanément ou au cours de la même étape, d'au moins une partie des premiers et deuxièmes éléments de contact, (reroutage horizontal et vias verticaux) avant positionnement des composants, permet de réaliser des tests de ces éléments de contact. Ainsi il est possible de faire ces tests entre les étapes des figures 1G et 1H, ou entre les étapes des figures 2E et 2F. L'identification d'une connexion défectueuse permettra sa réparation ou, en tout cas, aura permis d'identifier une zone où un composant 22 ne doit pas être disposé.

De même, lors d'une étape ultérieure, après que les composants 22 aient été installés, il est possible de réaliser un test de l'ensemble « moyens de connexion + composants ». Un tel test peut par exemple être réalisé à l'issue des étapes correspondant aux figures 1H et 2F ci-dessus.

L'élimination du substrat 2, après les étapes des figures 1J et 2I n'est pas systématique : ainsi dans le cas de composants électro-optiques ou optroniques 22, le substrat 2 peut être transparent dans une certaine gamme de longueurs d'onde et être maintenu, au moins en partie. Il se peut, également, que le support 2 soit actif: il s'agit alors, par exemple, d'un substrat en un matériau semi-conducteur, tel que du silicium, muni de fonctions ou de composants.

Les figures 4 et 5A-5C représentent divers dispositifs 100 de connexion, chacun de ceux des figures 5A-5C étant obtenu par un procédé selon l'invention. Dans ces dispositifs, le substrat 2 a été éliminé. Les composants 22 sont cependant très peu épais (leur épaisseur e est fortement exagérée sur les figures, pour des raisons de lisibilité) et ils définissent eux aussi le plan xOy, de même d'ailleurs que le reroutage horizontal, qui a été formé sur la surface 5. On retrouve, sur ces figures 4 et 5A-5C, des références numériques identiques à celles des figures précédentes, qui y désignent des éléments techniques similaires ou identiques. Dans les cas illustrés, les composants 22, enrobés dans un produit d'enrobage 24 sont reliés à un reroutage dans le plan xOy du substrat initial. Sur ces figures, seuls des plots de connexion 10, 34, sont visibles, mais le reroutage peut comporter en outre diverses pistes et d'autres plots dans ce plan du substrat initial. À ces plots de connexion sont également reliés des éléments conducteurs, ou vias, qui permettent d'orienter la connexion suivant la direction z, perpendiculaire au plan xOy. Dans les exemples des figures 5A-5C, ces éléments conducteurs comportent essentiellement des poutres ou bras 36, redressés à des degrés divers; dans le cas de la figure 5C, les éléments conducteurs situés hors du plan xOy sont même fortement courbés, jusqu'à ramener leur extrémité libre au-dessus du composant. Dans l'autre cas (figure 4) il s'agit des picots 4 recouverts d'une métallisation comme expliqué ci-dessus. Dans tous les cas on réalise un reroutage suivant une direction z perpendiculaire au plan du substrat initial 2 ou au plan, défini par les composants 22 et dans lequel ils sont formés.

Dans les exemples présentés sur les figures, deux vias sont répartis, de manière symétrique, de part et d'autre de chaque composant 22.

Cependant, d'autres nombres de vias et d'autres répartitions de vias sont possibles. Les figures 6A, 6B et 6C représentent schématiquement, en vue de dessus, un composant 22, et un ou plusieurs ensembles 40 de vias disposés de part et d'autre du composant (figure 6A), ou sur un seul côté du composant (figure 6B), ou sur deux côtés du composant mais pas forcément de manière symétrique (figure 6C). Ces dispositions de vias ne sont pas exhaustives : d'autres dispositions peuvent être réalisées, combinant par exemple plusieurs des dispositions de vias représentées sur les figures 6A-6C. Sur ces schémas, les pistes et les plots de reroutage horizontal ne sont pas représentés, mais peuvent, eux aussi, avoir toute forme ou répartition souhaitée lors de la conception.

Dans tous les modes de réalisation de l'invention présentés, les électrodes sont dirigées suivant une direction sensiblement perpendiculaire au plan du substrat initial 2 - quand bien même elles peuvent présenter une certaine courbure comme sur les figures 5A-5C - et sans être ramenées sous ce plan, vers un substrat support inférieur sur lequel les puces ou les composants reposeraient (ce qui est le cas des figures 11A et 11B).

Comme illustré sur la figure 7, une pluralité de ces éléments 100, 100', 100" de connexion selon l'invention peut être utilisée pour réaliser un empilement de composants. De cette figure il apparaît clairement que les différents niveaux de l'empilement sont en contact électrique les uns avec les autres par l'intermédiaire des vias 36, 36', 36'' disposés suivant la direction z. Sur cette figure, seuls des vias du type de ceux obtenus en liaison avec le procédé selon l'invention sont représentés, mais on pourrait tout aussi bien avoir un assemblage d'éléments comportant des vias des deux types, à savoir du type de ceux obtenus en liaison avec le procédé selon l'invention et des vias de type « picots », comme ceux de la figure 4.

L'invention peut donc être employée pour la réalisation d'un système complexe à partir de composants venant de différentes plaquettes.

Des structures plus complexes que celles de la figure 7 peuvent être élaborées, par exemple, du type illustré sur la figure 8, sur laquelle seuls deux niveaux de composants 100, 100' sont représentés, mais regroupant, dans un même ensemble (fabriqué à l'échelle d'un wafer ou substrat), un ASIC 22, un MEMS 22' et un composant RFID 22".

Il est également possible d'assembler un étage comportant un substrat reconstitué selon l'invention et un étage d'une autre nature, non obtenu par un procédé selon l'invention.

Une des applications de l'invention est notamment la réalisation de modules de mémoires à haute vitesse, favorisée par la faible longueur des pistes, qui résulte elle-même du reroutage vertical.

## Revendications

1. Procédé de réalisation d'un dispositif électronique (100, 100', 100") de connexion, comportant :
a) la formation, en surface d'un substrat (2), d'au moins un premier élément de contact (34), et, suivant au moins une direction non parallèle à ladite surface, d'au moins un deuxième élément de contact (36) présentant une première extrémité en contact avec le ou les premiers éléments de contact et une deuxième extrémité, le ou les deuxièmes éléments de contact comportant une ou des pistes, ou poutres ou bras, métalliques (36), d'abord formés dans une position parallèle à la surface du substrat, puis redressés, par l'effet de contraintes, depuis ladite position parallèle à la surface du substrat, vers un axe perpendiculaire à la surface du substrat, ladite deuxième extrémité étant maintenue au-dessus de la surface du substrat,
b) puis le positionnement d'au moins un composant électrique ou électronique (22) en contact avec le ou les premiers éléments de contact (34),
c) puis, l'enrobage du ou des composants et des premier et deuxième éléments de contact, au moins la ou les deuxièmes extrémités du ou des deuxièmes éléments de contact (36) affleurant la surface (37) de l'enrobage.

2. Procédé selon la revendication 1, au moins une partie du ou des premiers éléments de contact et au moins une partie du ou des deuxième éléments de contact étant réalisées simultanément au cours d'une même étape.

3. Procédé selon la revendication 1 ou 2, le ou les deuxièmes éléments de contact comportant un empilement d'au moins deux couches formant bilame.

4. Procédé selon l'une des revendications 1 à 3, le deuxième élément de contact étant une piste métallique ou les deuxièmes éléments de contact étant des pistes métalliques, la ou les pistes métalliques (36) étant redressées par effet mécanique ou par effet magnétique, ou la ou les pistes métalliques (36) étant au moins en partie magnétique, et étant redressées sous l'action d'un champ magnétique.

5. Procédé selon l'une des revendications 1 à 4, le deuxième élément de contact étant une piste métallique ou les deuxièmes éléments de contact étant des pistes métalliques, la ou les pistes métalliques (36) étant formées sur une couche sacrificielle (30) qui est ensuite éliminée.

6. Procédé selon l'une des revendications 1 à 5, comportant la formation, en surface du substrat, d'un ou plusieurs circuit(s) de reroutage horizontal, dont font partie le ou les premiers élément(s) de contact.

7. Procédé selon l'une des revendications 1 à 6, comportant en outre une étape de test des éléments de contact, avant l'étape b) et/ou une étape de test des composants, avant l'étape c).

8. Procédé selon l'une des revendications 1 à 7, comportant en outre une étape d'élimination du substrat (2).

9. Procédé de réalisation d'un dispositif électronique compact, comportant la réalisation d'au moins un premier dispositif selon l'une des revendications 1 à 8, et un empilement de ce dispositif avec un deuxième dispositif, qui peut avoir été obtenu selon un procédé selon l'une des revendications 1 à 8.

10. Dispositif électronique (100, 100', 100") de connexion, comportant :
a) dans un plan, au moins un premier élément de contact (34), et, suivant au moins une direction non parallèle audit plan, au moins un deuxième élément de contact (36) présentant une première extrémité en contact avec le premier élément de contact et une deuxième extrémité, le ou les deuxièmes éléments de contact comportant un empilement d'au moins deux couches formant bilame,
b) au moins un composant électrique ou électronique (22) en contact avec le ou les premiers éléments de contact (34),
c) un enrobage du ou des composants et des premiers et deuxièmes éléments de contact, au moins la deuxième extrémité du deuxième élément de contact (36) affleurant la surface (27) de l'enrobage, le ou les composant(s) étant situé(s) entre ledit plan et le plan parallèle audit plan et dans lequel la deuxième extrémité du deuxième élément de contact est située.

11. Dispositif selon la revendication 10, au moins une partie du premier élément de contact et au moins une partie du deuxième élément de contact comportant une couche continue (34, 36) de matériau conducteur.

12. Dispositif selon l'une des revendications 10 ou 11, comportant,dans ledit plan, un ou plusieurs circuits de reroutage horizontal, dont font partie le ou les premiers élément(s) de contact.

13. Dispositif selon la revendication précédente, comportant en outre une couche (26) de passivation sur le côté du dispositif opposé à la deuxième extrémité du deuxième élément de contact, le dispositif comportant de manière optionnelle des connexions électriques sur la couche de passivation.

14. Dispositif électronique compact, comportant au moins un premier dispositif selon l'une des revendications 10 à 13, et un empilement de ce dispositif avec un deuxième dispositif électronique, qui peut être un dispositif selon l'une des revendications 10 à 13.

## Patentansprüche

1. Verfahren zur Herstellung einer elektronischen Verbindungsvorrichtung (100, 100', 100"), umfassend:
a) Ausbilden von zumindest einem ersten Kontaktelement (34) an der Oberfläche eines Substrats (2) und in zumindest einer zu dieser Oberfläche nicht parallelen Richtung Ausbilden von zumindest einem zweiten Kontaktelement (36) mit einem ersten Ende in Kontakt mit dem bzw. den ersten Kontaktelement(en) und mit einem zweiten Ende, wobei das bzw. die zweite(n) Kontaktelement(e) eine oder mehrere metallische Bahnen oder Stege oder Arme (36) aufweist bzw. aufweisen, die zunächst in einer parallel zur Oberfläche des Substrats verlaufenden Position ausgebildet und dann unter Einwirkung von Spannungen ausgehend von der parallel zur Oberfläche des Substrats verlaufenden Position in Richtung einer senkrecht zur Oberfläche des Substrats verlaufenden Achse aufgestellt werden, wobei das zweite Ende über der Oberfläche des Substrats gehalten wird, dann
b) Positionieren zumindest einer elektrischen oder elektronischen Komponente (22) in Kontakt mit dem bzw. den ersten Kontaktelement(en) (34), dann
c) Beschichten der Komponente(n) und des ersten und zweiten Kontaktelements, wobei zumindest das zweite Ende bzw. die zweiten Enden des bzw. der zweiten Kontaktelemente (36) mit der Oberfläche (37) der Beschichtung bündig verläuft bzw. verlaufen.

2. Verfahren nach Anspruch 1, wobei zumindest ein Teil des bzw. der ersten Kontaktelemente und zumindest ein Teil des bzw. der zweiten Kontaktelemente gleichzeitig in demselben Schritt hergestellt werden.

3. Verfahren nach Anspruch 1 oder 2, wobei das bzw. die zweiten Kontaktelemente eine Stapelung von zumindest zwei Bimetallschichten aufweist bzw. aufweisen.

4. Verfahren nach einem der Ansprüche 1 bis 3, wobei das zweite Kontaktelement eine Metallbahn ist bzw. die zweiten Kontaktelemente Metallbahnen sind, wobei die Metallbahn(en) (36) durch mechanische Wirkung oder durch magnetische Wirkung aufgestellt werden, oder wobei die Metallbahn(en) (36) zumindest teilweise magnetisch ist bzw. sind und unter der Einwirkung eines Magnetfelds aufgestellt werden.

5. Verfahren nach einem der Ansprüche 1 bis 4, wobei das zweite Kontaktelement eine Metallbahn ist bzw. die zweiten Kontaktelemente Metallbahnen sind, wobei die Metallbahn(en) (36) auf einer Opferschicht (30) gebildet werden, die anschließend entfernt wird.

6. Verfahren nach einem der Ansprüche 1 bis 5, umfassend das Ausbilden eines oder mehrerer horizontaler Umleitungskreise an der Oberfläche des Substrats, von dem bzw. denen das bzw. die ersten Kontaktelemente ein Teil ist bzw. sind.

7. Verfahren nach einem der Ansprüche 1 bis 6, ferner umfassend einen Schritt des Testens der Kontaktelemente vor Schritt b) und/oder einen Schritt des Testens der Komponenten vor Schritt c).

8. Verfahren nach einem der Ansprüche 1 bis 7, ferner umfassend einen Schritt des Entfernens des Substrats (2).

9. Verfahren zum Herstellen einer kompakten elektronischen Vorrichtung, umfassend das Herstellen zumindest einer ersten Vorrichtung nach einem der Ansprüche 1 bis 8 und das Stapeln dieser Vorrichtung mit einer zweiten Vorrichtung, die mit einem Verfahren nach einem der Ansprüche 1 bis 8 erhalten worden kann.

10. Elektronische Verbindungsvorrichtung (100, 100', 100"), enthaltend:
a) in einer Ebene zumindest ein erstes Kontaktelement (34) und in einer zu dieser Ebene nicht parallelen Richtung zumindest ein zweites Kontaktelement (36) mit einem ersten Ende in Kontakt mit dem ersten Kontaktelement und einem zweiten Ende, wobei das bzw. die zweiten Kontaktelemente eine Stapelung von zumindest zwei Bimetallschichten enthält bzw. enthalten,
b) zumindest eine elektrische oder elektronische Komponente (22) in Kontakt mit dem bzw. den ersten Kontaktelementen (34),
c) eine Beschichtung der Komponente bzw. der Komponenten und der ersten und zweiten Kontaktelemente, wobei zumindest das zweite Ende des zweiten Kontaktelements (36) bündig mit der Oberfläche (27) der Beschichtung verläuft, wobei die Komponente bzw. die Komponenten zwischen der Ebene und der parallel zur Ebene verlaufenden Ebene liegt bzw. liegen, in welcher das zweite Ende des zweiten Kontaktelement liegt.

11. Vorrichtung nach Anspruch 10, wobei zumindest ein Teil des ersten Kontaktelements und zumindest ein Teil des zweiten Kontaktelements eine durchgehende Schicht (34, 36) aus leitfähigem Material umfassen.

12. Vorrichtung nach einem der Ansprüche 10 oder 11, enthaltend einen oder mehrere horizontale Umleitungskreise in der Ebene, von dem bzw. denen das bzw. die ersten Kontaktelemente ein Teil ist bzw. sind.

13. Vorrichtung nach dem vorangehenden Anspruch, ferner enthaltend eine Passivierungsschicht (26) auf der dem zweiten Ende des zweiten Kontaktelements entgegengesetzten Seite der Vorrichtung, wobei die Vorrichtung optional elektrische Verbindungen an der Passivierungsschicht enthält.

14. Kompakte elektronische Vorrichtung mit zumindest einer ersten Vorrichtung nach einem der Ansprüche 10 bis 13 und einer Stapelung dieser Vorrichtung mit einer zweiten elektronischen Vorrichtung, die eine Vorrichtung nach einem der Ansprüche 10 bis 13 sein kann.

## Claims

1. Method of producing an electronic connection device (100, 100', 100''), comprising:
a) the formation, at the surface of a substrate (2), of at least one first contact element (34), and, in at least one direction not parallel to said surface, of at least one second contact element (36) having a first end in contact with the first contact element or elements and a second end, the second contact element or elements comprising one or more metal tracks, or beams or arms (36), firstly formed in a position parallel to the surface of the substrate, then standing up by the effect of stresses , from said position parallel to the surface of the substrate, towards an axis perpendicular to the surface of the substrate, said second end being maintained above the surface of the substrate;
b) then the positioning of at least one electrical or electronic component (22) in contact with the first contact element or elements (34),
c) then, the encapsulation of the component(s) and of the first and second contact elements, at least the second end or ends of the second contact element or elements (4, 36) being flush with the surface (27) of the encapsulating material.

2. Method according to claim 1, at least one part of the first contact element or elements and at least one part of the second contact element or elements being formed simultaneously during a same step.

3. Method according to claim 1 or 2, the second contact element or elements comprising a stacking of at least two layers forming a bimetallic element.

4. Method according to one of claims 1 to 3, the second contact element being a metal track or the second contact elements being metal tracks (36), the metal track or tracks (36) being made to stand up by mechanical effect or by magnetic effect or the metal track or tracks (36) being at least in part magnetic, and being made to stand up under the action of a magnetic field.

5. Method according to one of claims 1 to 4, the second contact element being a metal track or the second contact elements being metal tracks (36), the tracks (36) being formed on a sacrificial layer (30), which is then removed.

6. Method according to one of claims 1 to 5, comprising the formation, on the surface of the substrate, of one or more rerouting circuits, of which the first contact element or elements form part.

7. Method according to one of claims 1 to 6, further comprising a step of testing contact elements, before step b) and/or a step of testing components, before step c).

8. Method according to one of claims 1 to 7, further comprising a step of removing the substrate (2) .

9. Method of producing a compact electronic device, comprising the formation of at least one first device according to one of claims 1 to 8, and a stacking of this device with a second device that may have been obtained according to a method according to one of claims 1 to 8.

10. Electronic connection device (100, 100', 100''), comprising:
a) in a plane, at least one first contact element (10, 34), and, in a direction not parallel to said plane, at least one second contact element (36) having a first end in electrical contact with the first contact element and a second end, the second contact element or elements comprising a stacking of at least two layers forming a bimetallic element,
b) at least one electrical or electronic component (22) in contact with the first contact element or elements (34),
c) an encapsulation of the component(s) and of the first and second contact element or elements, at least the second end of the second contact element (36) being flush with the surface (27) of the encapsulating material, the component(s) being located between said plane and the plane parallel to said plane and in which the second end of the second contact element is located.

11. Device according to claim 10, at least one part of the first contact element and at least one part of the second contact element comprising a continuous layer (34, 36) of conducting material.

12. Device according to one of claims 10 or 11, comprising, in said plane, one or more horizontal rerouting circuits, of which the first contact element(s) form part.

13. Device according to the preceding claim, further comprising a passivation layer (26) on the side of the device opposite to the second end of the second contact element, the device optionally comprising electrical connections on the passivation layer.

14. Compact electronic device, comprising at least one first device according to one of claims 10 to 13, and a stacking of this device with a second electronic device, which may be a device according to one of claims 10 to 13.
